# EUROPEAN PATENT SPECIFICATION

(11) **EP 2 313 790 B1**
(45) Date of publication and mention of the grant of the patent: **16.05.2012**
(21) Application number: 09779006.7
(22) Date of filing: 03.02.2009
(51) Int. Cl.: H02H 5/08, H02H 3/087, G01R 31/02

(54) **PROTECTION CIRCUIT**
SCHUTZSCHALTUNG
CIRCUIT DE PROTECTION

(30) Priority: 05.08.2008 US 185958
(43) Date of publication of application: 27.04.2011
(73) Proprietor: Sony Ericsson Mobile Communications AB, 221 88 Lund (SE)
(72) Inventor: SIMON, Karoly, S-261 52 Landskrona (SE)
(74) Representative: VALEA AB
(86) International application number: PCT/EP2009/051169
(87) International publication number: WO 2010/015425

(56) References cited:
- JP-A- 2001 037 244
- US-A- 3 686 530
- US-A- 5 559 500
- US-A1- 2007 139 844

## Description

### TECHNICAL FIELD

The present invention relates to a method and device for protecting electrical parts of an electrical device generally, and protecting the device against short circuiting specially.

### BACKGROUND

Communication devices, such as cellular telephones, have become increasingly versatile. For example, cellular telephones today often include applications that allow users to do more than just make and receive telephone calls, such as send/receive text messages, play music, play video games, take pictures, etc. As a result, cellular telephones have become an increasingly common part of every day life for a large number of users.

The becoming of the common part of every day life means that the cell phone is carried around in and exposed to different environments, e.g. high humidity, water and other liquids. For example the cell phone may be exposed to torrential rain or dropped into water. The housing of the cell phone usually will not stand such environments and water will leak into the housing.

High level of moisture, high humidity or conductive liquids inside an electrical device may cause short circuit, which may destroy the device and in worse case injure the user.

US 3,686,530 relates to a battery pack including a resettable protection circuit for limiting the current to a load, which includes a normally nonconductive silicon controlled rectifier and a magnetic reed switch serially connected across a battery. When excessive load current develops, the silicon controlled rectifier is rendered conductive which in turn cuts off a regulating transistor or energizes a relay to prevent current flow to the load. The battery, magnetic reed switch, silicon controlled rectifier and regulating transistor or relay are encased in a sealed container to prevent sparks and arcing and allow usage in a hazardous atmosphere. The silicon controlled rectifier is reset, to allow continued usage of the battery, by actuating the reed switch with an externally supplied magnetic field. Actuation of the reed switch breaks the current path to the silicon controlled rectifier. The device of this document is not intended for detecting short circuit due to conductive media in an electrical device, although a short circuit causes excessive load current. This document also does not disclose or suggest arranging sensors around the electrical components of the electrical device for protecting the same.

### SUMMARY

Thus, there is a need for an arrangement to protect electrical devices against short circuiting due to high level of moisture, high humidity or conductive liquid inside the device.

For this reason the invention provides a method for detecting and protecting an electrical device against short circuit due to presence of a conductive subject. The method comprises the steps of: using a first and second probe, the first probe being connected to ground and the second probe being connected to a detecting device, detecting a short circuit between the first and second probes, and controlling a switching element to interrupt power supply from a power source to one or several of electrical components of the electrical device.

The invention also relates to an arrangement for detecting and protecting an electrical device against short circuit due to presence of a conductive subject. The arrangement comprises: a first and second probe, the first probe being connected to ground and the second probe being connected to a detecting device, the detecting device being configured to detect a short circuit between the first and second probes, and output a signal to interrupt power supply from a power source to one or several of electrical components of the electrical device. Most preferably, the probes are arranged on a carrying structure for carrying electrical components of the device. Advantageously, the probes are arranged as loops. The carrying structure is a PCB. In one embodiment, the switching element is a transistor and the power source is a battery. Preferably, a distance between said probes is sufficient enough to detect presence of said conductive subject. The probes may be located close to a specific place and/or component. According to one embodiment several probes are arranged in parallel for detection at different places at the same time.

The invention also relates to a mobile communication terminal comprising an antenna for receiving/transmitting RF signals as between the terminal and a cell site antenna of a wireless/cellular telecommunications network, a transceiver associated with the antenna for processing incoming and outgoing signals, call processing components for controlling operation of the terminal, and user interface components for providing an interface between the terminal and a user. The mobile communication terminal further comprises an arrangement for detecting and protecting the terminal against short circuit due to presence of a conductive subject. The arrangement comprises: a first and second probe, the first probe being connected to ground and the second probe being connected to a detecting device, the detecting device being configured to detect a short circuit between the first and second probes, and output a signal to interrupt power supply from a power source to one or several of electrical components of the mobile communication terminal.

### BRIEF DESCRIPTION OF THE DRAWINGS

The accompanying drawings, which are incorporated in and constitute a part of this specification, illustrate an embodiment of the invention and, together with the description, explain the invention. In the drawings:
- Fig. 1: is a perspective view of a portable telephone in connection with which the present invention can be used;
- Fig. 2: is a schematic diagram of a portable telephone system in accordance with the present invention; and
- Fig. 3: is a schematic top view of a PCB comprising a senor according to present invention;
- Fig. 4: is a schematic diagram of a protection system in accordance with the present invention; and
- Fig. 5: is a schematic diagram of a short circuit detection circuit in accordance with the present invention.

### DETAILED DESCRIPTION

A "device," as the term is used herein, is to be broadly interpreted to include any electrical device, especially portable device, which may be damaged due to expose to a short circuiting medium; such a device may include: a personal communications system (PCS) terminal that may combine a cellular radiotelephone with data processing; a personal digital assistant (PDA) that can include a radiotelephone, pager, Internet/intranet access, web browser, organizer, calendar, a camera (e.g., video and/or still image camera), a sound recorder, and/or global positioning system (GPS) receiver; a GPS device; a camera (e.g., video and/or still image camera); a sound recorder; and any other computation or communication device capable of displaying media, etc.

In the following the invention is described in an exemplary way with reference to a wireless communication terminal, such as a cell phone.

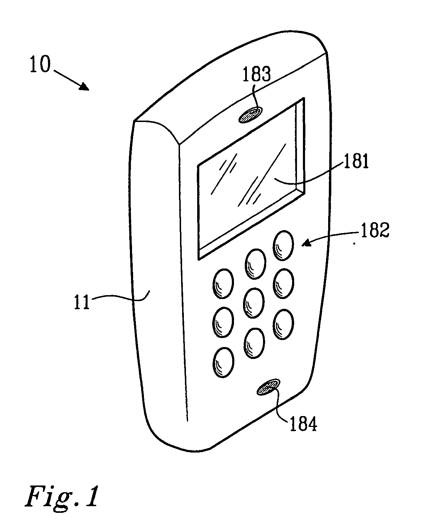

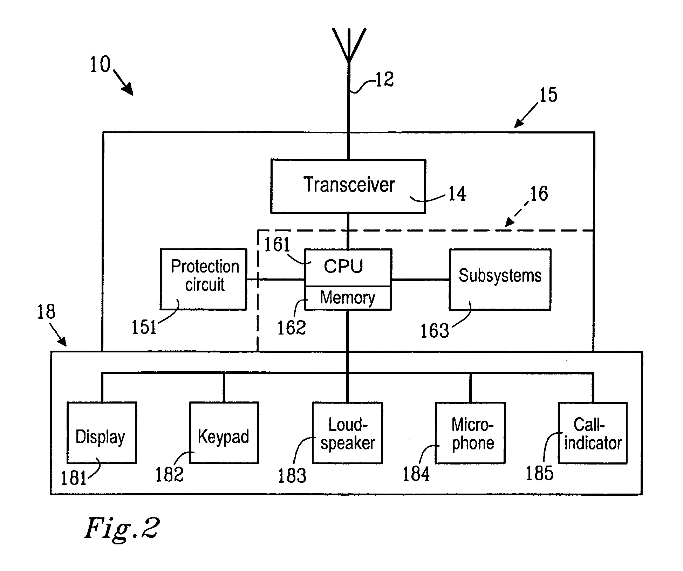

Referring now to Figs. 1 and 2, a mobile communication terminal system 10 or handset (cell phone) is illustrated. Generally, the handset 10 includes: a hosing 11 including an antenna 12 for receiving/transmitting RF signals as between the handset 10 and a cell site antenna of a wireless/cellular telecommunications network; transceiver 14 associated with the antenna 12 for processing incoming and outgoing signals, call processing components 16 for controlling operation of the handset 10, and user interface components 18 for providing an interface between the handset 10 and the user. The transceiver 14 and the processing components are normally arranged on a carrying structure such as a Printed Circuit Board, PCB, 15.

The transceiver 14 may include an incoming signal processing unit and an outgoing call processing unit (not shown). The incoming signal processing unit performs a number of functions relative to an incoming call signal including: filtering the incoming signal to remove unnecessary wavelength bands, demodulating the high frequency carrier signal and converting the signal into a digital format for processing by the call processing component 16. The outgoing call processing unit performs a number of functions relative to transmitting a signal including processing a voice or other signal for transmission, synthesizing the communication signal to apply a reference frequency, modulating the communication signal into a high frequency carrier signal and filtering the resulting signal for transmission.

The call processing components 16 includes a processor (CPU) 161 and a memory 162, and subsystem 163, including for example a timing subsystem, a call indicator control subsystem, messaging subsystem and I/O units. The processor 161 controls operation of the various components of the handset 10. In this regard, the processor 161 receives an incoming signal from the incoming signal processing unit, and notifies the subscriber of the incoming call. The processor 161 also communicates with cell site/switch equipment via the outgoing call processing unit 16 and antenna 12 to establish a channel for communication as between the handset 10 and a calling telephone that originated the incoming call signal. With respect to outgoing calls, the processor 161 receives information from the user interface components 18, e.g., a phone number and transmit signal, communicates with cell site/switch equipment via the transceiver 14 and antenna 12 to establish a communications channel, transmits a call request and waits for a response from the called telephone/network. During a phone conversation, the processor 161 receives voice communications from the user interface components 18, transmits the voice communications, receives incoming signals, transmits voice communications to the user interface components 18, and detects any operating signals such as a hang up signal.

The user interface components 18 may include a number of devices for communicating with the subscriber. The display 181 provides a visual presentation of a phone number entered by the user, information regarding an incoming call and/or various operating information such as status of the handset's battery. The keypad 182 may include buttons corresponding to the numbers 0-9 for entering phone numbers or other numerical information as well as various other buttons such as "end", "off", "#", "*", "flash", "send", or other buttons. The ear piece 183 or a loudspeaker receives communication information from the processor 161 and provides audio signals to the subscriber. Microphone 184 receives voice or other audio signals from the subscriber and provides corresponding communication signals to the processor 161. Finally, the call indicator 185 provides a signal to the subscriber that notifies the subscriber of an incoming call. For example, the call indicator 185 may be a ringer or other device for providing an audio indication, a vibrator, or any other device which provides a signal that is perceptible by the subscriber. The terminal 10 according to the present invention further include a protection arrangement 151, which comprises a sensor portion and a circuit.

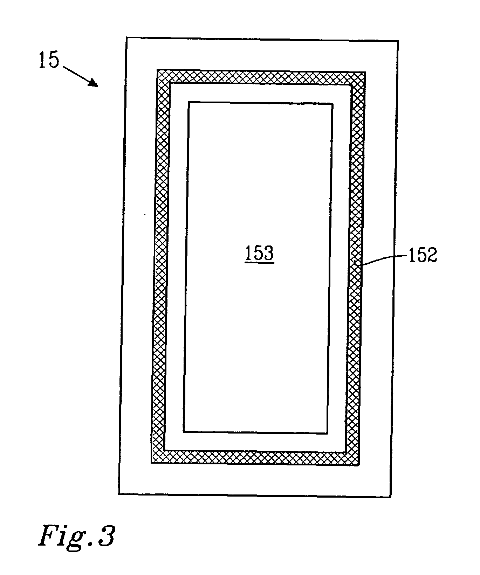

Fig. 3 illustrates a top view of the carrying structure, a PCB 15, for carrying some or parts of electrical components of the handset. The PCB, in one or several layers, comprises conductors (not shown) coupling the components (not shown) together. The PCB 15 is provided with a ground loop 152, which surrounds the PCB 15. A second loop 153 (sensor loop) of a conductive material is arranged inside the ground loop 152. This second loop 153 is configured as a sensor loop and will be referred to as sensor loop in the following. The ground loop 152 and the sensor loop 153 function as probes. The sensor loop can easily be made of a copper or any other conductive material wire trace around the PCB. Both the ground loop and the sensor loop may be arranged in specific location surrounding the electrical parts.

The probes may have any shape. The do not need to be formed as loops. However, it is important is that the distance between the two probes are small enough. It can be also located close to some specific place/component. It is also possible to have several probes in parallel so that is possible to measure at different places at the same time.

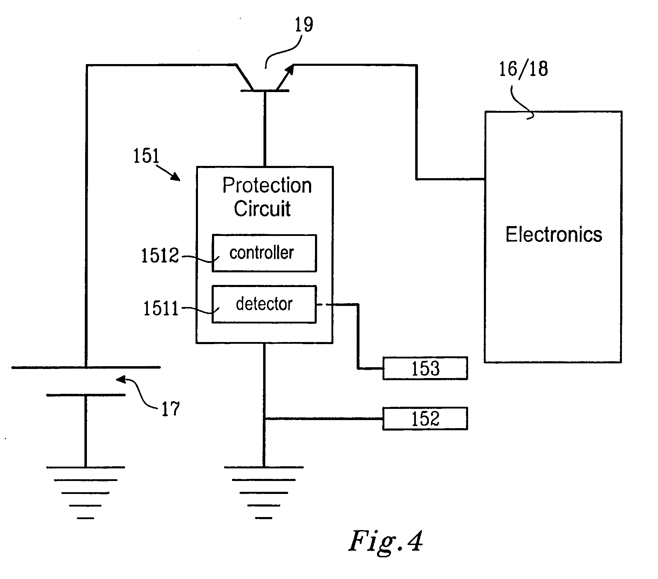

Fig. 4 illustrates the block diagram of the protection arrangement according to the invention in the handset, comprising a power source 17, a switching element 19, the protection circuit 151, ground probe 152, sensor probe 153 and the main electronics 16 and 18 as mentioned above. The switching element 19 is represented by a NPN transistor, but may comprise other types of switching elements and other types of transistors. The protection circuit may comprise a detection portion 1511 and a control portion 1512. The detection portion 1511 detects a voltage fall and or current rush between the probes 152 and 153. The controlling portion 1512 may control the switching element 19 directly or by outputting a signal to, for example CPU 161, which controls the switching element 19.

The idea is that if the terminal detects presence of a conductive medium which can short circuit the electrical components near the electronics, it disables the power from the power source, e.g. battery, to avoid a short circuit in the electrical components. The power source may, beside a battery, comprise an output from a power adapter, a capacitor etc. In the following the invention is described with reference to a battery as the power source.

The battery 17 at its plus terminal is connected to the collector terminal of the transistor 19, which is controlled by the protection circuit at its base terminal and connected to the main electronics at its emitter terminal. The protection circuit 151 is connected to the sensor probe 153 and may be connected ground probe 152 directly or through common ground.

Basically, the current from the battery 17 runs thru the transistor 19 before supplying the main electronics with power. The transistor 19 is controlled, i.e. switches of and on power, by the protection circuit 151 that uses the sensor probes 152 and 153 to monitor if there is a conductive subject such as high humidity, water or any other conductive liquid or not in the handset.

The sensor probe 153 can easily be made of a conductive wire trace (copper, gold, etc.) around the PCB as shown in Fig. 3. When there is, e.g. water, then the water drops short circuit the sensor trace to ground, which is detected by the protection circuit which controls the transistor 19 to disconnect the battery.

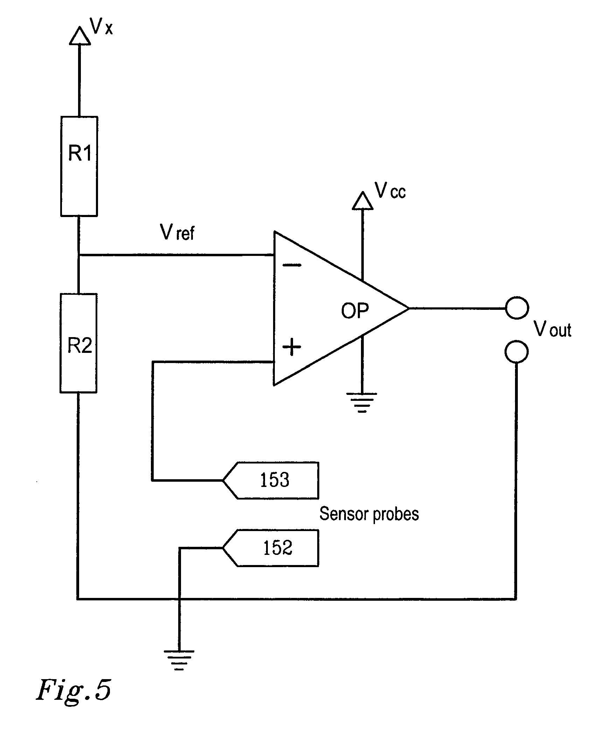

Fig. 5 illustrates a simple detecting circuit 50 for short circuit. The circuit comprises an operation amplifier (OP) 51 connected to the sensor probe 153 at its non inverting input (+). As long as the sensor probes 152 and 152 are not short circuited the output of the OP is high. When short circuited between probes 152 and 153, the output of the OP goes low which generates a signal to break (or controls) the switching element, mentioned above, to interrupt the power supply to the electronics of the phone via the controller circuit. The level a reference voltage (V_{ref}) connected t the inverting input (-) of the OP is set to a proper level to avoid a false triggering. This is done using R1/R2. Vₓ connected through R1 should be a regulated reference voltage of good quality. This detection device is given as en example and many other types of detection devices may be used.

According to one embodiment of the invention, it will not be possible to turn on the phone again unless the battery has been removed and put back again. However, in one embodiment, the protection circuit may disconnect the power until all short circuiting subjects are removed.

The principles of the invention may be used for any product that may be subjected to short circuiting due to high humidity, or exposure to conductive liquids inside the housing.

It should be noted that the word "comprising" does not exclude the presence of other elements or steps than those listed and the words "a" or "an" preceding an element do not exclude the presence of a plurality of such elements. It should further be noted that any reference signs do not limit the scope of the claims, that the invention may be implemented at least in part by means of both hardware and software, and that several "means", "units" or "devices" may be represented by the same item of hardware.

The above mentioned and described embodiments are only given as examples and should not be limiting to the present invention. Other solutions, uses, objectives, and functions within the scope of the invention as claimed in the below described patent claims should be apparent for the person skilled in the art.

## Claims

1. A method of detecting a potential short-circuit due to presence of a conductive media in an electrical device, the method comprising the steps of:
• detecting a short circuit between a first sensor portion (152) and a second sensor portion (153), said first sensor portion (152) being connected to ground in said electrical device and said second sensor portion (153) being connected to a detecting device (1511) and said first and second sensor portions arranged surrounding one or several of electrical components, and
• based on the detection of short circuit, controlling a switching element (19) in the electrical device to interrupt a power supply from a power source to one or more of electrical components of said electrical device.

2. An arrangement (151) for detecting presence of a conductive media in an electrical device,
**characterised in that** the arrangement comprises:
• a first sensor portion (152) connected to ground of said electrical device,
• a second sensor portion (153) connected to a detecting device (1511),
• said first and second sensor portions surround said one or several of electrical components,
• wherein said detecting device is configured to detect a short circuit between said first and second sensor portions, and output a signal to interrupt power supply from a power source (17) to one or several of electrical components (16; 18) of said electrical device.

3. The arrangement of claim 2, wherein said sensor portions are arranged on a carrying structure for carrying electrical components of said device.

4. The arrangement of claim 2, wherein said sensor portions are arranged as loops.

5. The arrangement of claim 3, wherein said carrying arrangement is a PCB.

6. The arrangement of claim 2, wherein said switching element is a transistor.

7. The arrangement of claim 2, wherein said power source is a battery.

8. The arrangement of claim 2, wherein a distance between said sensor portions is sufficient enough to detect presence of said conductive subject.

9. The arrangement of claim 2, wherein said sensor portions are located close to a specific place and/or component.

10. The arrangement of claim 2, comprising several sensor portions in parallel for detection at different places at the same time.

11. A mobile communication terminal (10) comprising an antenna (12) for receiving/transmitting RF signals as between the terminal and a cell site antenna of a wireless/cellular telecommunications network, a transceiver (14) associated with the antenna (12) for processing incoming and outgoing signals, call processing components (16) for controlling operation of the terminal, and user interface components (18) for providing an interface between the terminal and a user, **characterised *by*** an arrangement for detecting presence of a conductive media according to any of claims 2-10.

## Patentansprüche

1. Verfahren zum Erfassen eines möglichen Kurzschlusses aufgrund eines Vorhandenseins eines leitenden Mediums in einer elektrischen Vorrichtung, wobei das Verfahren die Schritte umfasst:
- Erfassen eines Kurzschlusses zwischen einem ersten Sensorabschnitt (152) und einem zweiten Sensorabschnitt (153), wobei der erste Sensorabschnitt (152) in der elektrischen Vorrichtung mit Masse verbunden ist und der zweite Sensorabschnitt (153) mit einer Erfassungsvorrichtung (1511) verbunden ist und der erste und zweite Sensorabschnitt eine oder mehrere elektrische Komponenten umgebend angeordnet sind, und
- Steuern eines Schaltelements (19) in der elektrischen Vorrichtung auf der Grundlage der Erfassung eines Kurzschlusses, um eine Energieversorgung von einer Energiequelle zu einer oder mehreren elektrischen Komponenten der elektrischen Vorrichtung zu unterbrechen.

2. Anordnung (151) zum Erfassen eines Vorhandenseins eines leitenden Mediums in einer elektrischen Vorrichtung,
**dadurch gekennzeichnet, dass** die Anordnung umfasst:
- einen ersten Sensorabschnitt (152), welcher mit Masse der elektrischen Vorrichtung verbunden ist,
- einen zweiten Sensorabschnitt (153), welcher mit einer Erfassungsvorrichtung (1511) verbunden ist,
- wobei der erste und zweite Sensorabschnitt die eine oder mehrere elektrische Komponenten umgeben,
- wobei die Erfassungsvorrichtung ausgestaltet ist, einen Kurzschluss zwischen dem ersten und zweiten Sensorabschnitt zu erfassen und ein Signal auszugeben, um eine Energieversorgung von einer Energiequelle (17) zu einer oder mehreren elektrischen Komponenten (16; 18) der elektrischen Vorrichtung zu unterbrechen.

3. Anordnung nach Anspruch 2, wobei die Sensorabschnitte auf einer Trägerstruktur zum Aufnehmen elektrischer Komponenten der Vorrichtung angeordnet sind.

4. Anordnung nach Anspruch 2, wobei die Sensorabschnitte als Schleifen ausgestaltet sind.

5. Anordnung nach Anspruch 3, wobei die Trägeranordnung eine Leiterplatte ist.

6. Anordnung nach Anspruch 2, wobei das Schaltelement ein Transistor ist.

7. Anordnung nach Anspruch 2, wobei die Energiequelle eine Batterie ist.

8. Anordnung nach Anspruch 2, wobei ein Abstand zwischen den Sensorabschnitten ausreichend genug ist, um ein Vorhandensein des leitenden Gegenstands zu erfassen.

9. Anordnung nach Anspruch 2, wobei die Sensorabschnitte nahe bei einer speziellen Stelle und/oder Komponente angeordnet sind.

10. Anordnung nach Anspruch 2, umfassend mehrere Sensorabschnitte nebeneinander für ein Erfassen an unterschiedlichen Stellen zur gleichen Zeit.

11. Mobiles Kommunikationsendgerät (10) umfassend eine Antenne (12) zum Empfangen/Übertragen von Funkfrequenzsignalen, wie z. B. zwischen dem Endgerät und einer Zellenstandortantenne eines drahtlosen/zellularen Telekommunikationsnetzes, eine Sende-/Empfangsvorrichtung (14), welche der Antenne (12) zugeordnet ist, zum Verarbeiten eingehender und ausgehender Signale, Anrufverarbeitungskomponenten (16) zum Steuern eines Betriebs des Endgerätes, und Benutzerschnittstellenkomponenten (18) zum Bereitstellen einer Schnittstelle zwischen dem Endgerät und einem Benutzer, **gekennzeichnet durch** eine Anordnung zum Erfassen eines Vorhandenseins eines leitenden Mediums nach einem der Ansprüche 2-10.

## Revendications

1. Procédé de détection d'un court-circuit potentiel dû à la présence d'un milieu conducteur dans un dispositif électrique, le procédé comprenant les étapes consistant à :
. détecter un court-circuit entre une première partie de capteur (152) et une deuxième partie de capteur (153), ladite première partie de capteur (152) étant connectée à la masse dans ledit dispositif électrique et ladite deuxième partie de capteur (153) étant connectée à un dispositif de détection (1511), et lesdites première et deuxième parties de capteur étant disposées de façon à entourer un ou plusieurs composants parmi des composants électriques,
. en fonction de la détection d'un court-circuit, commander un élément de commutation (19) dans le dispositif électrique de façon à interrompre une alimentation à partir d'une source d'alimentation vers un ou plusieurs des composants électriques dudit dispositif électrique.

2. Agencement (151) pour détecter la présence d'un milieu conducteur dans un dispositif électrique,
**caractérisé en ce que** l'agencement comprend :
. une première partie de capteur (152) connectée à la masse dudit dispositif électrique,
. une deuxième partie de capteur (153) connectée à un dispositif de détection (1511),
. lesdites première et deuxième parties de capteur entourant lesdits composants au nombre d'un ou de plusieurs parmi les composants électriques,
. dans lequel ledit dispositif de détection est configuré de façon à détecter un court-circuit entre lesdites première et deuxième parties de capteur, et à délivrer en sortie un signal afin d'interrompre une alimentation à partir d'une source d'alimentation (17) vers un ou plusieurs composants parmi des composants électriques (16 ; 18) dudit dispositif électrique.

3. Agencement selon la revendication 2, dans lequel lesdites parties de capteur sont disposées sur une structure de support pour supporter des composants électriques dudit dispositif.

4. Agencement selon la revendication 2, dans lequel lesdites parties de capteur sont agencées sous la forme de boucles.

5. Agencement selon la revendication 3, dans lequel ledit agencement de support est une carte de circuits imprimés.

6. Agencement selon la revendication 2, dans lequel ledit élément de commutation est un transistor.

7. Agencement selon la revendication 2, dans lequel ladite source d'alimentation est une pile ou une batterie.

8. Agencement selon la revendication 2, dans lequel une distance entre lesdites parties de capteur est suffisante pour détecter la présence dudit objet conducteur.

9. Agencement selon la revendication 2, dans lequel lesdites parties de capteur sont disposées à proximité d'un emplacement et/ou d'un composant spécifique.

10. Agencement selon la revendication 2, comprenant plusieurs parties de capteur en parallèle pour la détection en différents emplacements en même temps.

11. Terminal de communications mobile (10), comprenant une antenne (12) pour recevoir/émettre des signaux à fréquence radio, par exemple entre le terminal et une antenne de site de cellule d'un réseau de télécommunications sans fil/cellulaire, un émetteur/récepteur (14) associé à l'antenne (12) pour traiter des signaux entrants et sortants, des composants de traitement d'appel (16) pour commander le fonctionnement du terminal, et des composants d'interface d'utilisateur (18) pour constituer une interface entre le terminal et un utilisateur, **caractérisé par** un agencement pour détecter la présence d'un milieu conducteur selon l'une quelconque des revendications 2 à 10.
